# EUROPEAN PATENT APPLICATION

(11) **EP 3 421 639 A2**
(43) Date of publication of application: **02.01.2019**
(21) Application number: 18180772.8
(22) Date of filing: 29.06.2018
(51) Int. Cl.: C23C 16/44, H01J 37/32, B01D 53/74, F04C 19/00, F04C 29/00

(54) **EXHAUST-FACILITY SYSTEM**

(30) Priority: 29.06.2017 JP 2017127740; 02.02.2018 JP 2018016913
(71) Applicant: Ebara Corporation, Tokyo 144-8510 (JP)
(72) Inventor: MAISHIGI, Keiji, Tokyo, 144-8510 (JP); SUGIURA, Tetsuro, Tokyo, 144-8510 (JP); HSIANG HUANG, Lu, Tokyo, 144-8510 (JP); HARADA, Minoru, Tokyo, 144-8510 (JP)
(74) Representative: Schmidbauer, Andreas Konrad

(57) **Abstract**

An exhaust system facility that reduces the residual amount of byproducts inside the exhaust system facility to further enhance the operation rate of the exhaust system facility is provided. A vacuum pump 10 is installed downstream of a chamber 14 of a semiconductor manufacturing apparatus 12 to exhaust the inside of the chamber 14. A gas supply device 18 is connected to the vacuum pump 10 to supply a gas containing hydrogen halide and nitrogen to the vacuum pump 10.

## Description

The present invention relates to an exhaust-facility system.

In a manufacturing apparatus for manufacturing a semiconductor device, a liquid crystal panel, LED, a solar battery or the like, a process gas is introduced into an evacuated process chamber, and various kinds of processing such as film formation processing and etching processing are performed. In order to evacuate the inside of the chamber of the manufacturing apparatus, an exhaust system facility is installed downstream of the chamber of the manufacturing apparatus. The exhaust system facility includes a vacuum pump, an abatement apparatus, a pipe for connecting the vacuum pump and the abatement apparatus to each other, a pipe for connecting the chamber and the vacuum pump or the abatement apparatus, and the like.

The vacuum pump evacuates a process chamber for performing various kinds of processing such as film formation processing and etching processing. Since the process gas contains a silane-based gas (SiH₄, TEOS or the like), adversely affects the human body and adversely affects the global environment due to causing global warming or the like, it is not preferable to release the process gas as it is to the atmosphere. Therefore, these exhaust gases are detoxified by an abatement apparatus installed downstream of the vacuum pump and then released to the atmosphere.

The vacuum pump exhausts the gas inside the chamber in order to maintain the chamber of the semiconductor manufacturing apparatus in a vacuum state. Since film forming gas to be supplied to the inside of the chamber contains a gas that generates byproducts, the byproducts flow into the vacuum pump and the like together with the exhaust gas, or byproducts are generated inside the pump or the like. The byproducts to be brought into the vacuum pump or the byproduct generated inside the pump are caught in a gap between rotors of the vacuum pump or between the rotor and a casing for housing the rotor or the like. For this reason, the byproducts inhibit the normal rotation of the vacuum pump.

Gases that generate byproducts are gases necessary for wafer film formation processing (manufacturing process) which is an object of the semiconductor manufacturing apparatus, etc. The function of the vacuum pump is based on the premise that all the gases supplied to the manufacturing apparatus are exhausted, and it is impossible to avoid generation of byproducts. Users of semiconductor manufacturing apparatuses desire that the vacuum pump does not stop when the semiconductor manufacturing apparatuses manufacture products (during the film formation processing). This is because when the vacuum pump stops during the film formation processing, all products under manufacture must be discarded, so that undesirable costs will occur. Further, in order to enhance the operation rate of the manufacturing apparatus, the users desire to extend a continuous operation time of the vacuum pump so as not to stop the vacuum pump until a pump maintenance time (for example, a periodical replacement timing of the vacuum pump).

It has been proposed in a technique described in Japanese Patent No. 5562144 to perform product countermeasure operation for scraping deposits in order to prevent byproducts of a process gas from accumulating to the extent that the accumulated byproducts disturb rotation of the rotor.

As another preventive measure, suppression of the formation of byproducts or prevention of solidification of byproducts is carried out by decreasing or increasing the temperature of the pump. Specifically, products are reduced by using heat of compression generated by the vacuum pump, a heater installed in the vacuum pump, and cooling water circulating outside the vacuum pump. In this case, the temperature of the pump is decreased or increased in consideration of the temperature peculiar to the product (reaction temperature and sublimation temperature). In the above prior art, byproducts whose solidification cannot be prevented by decreasing or increasing the temperature of the pump remains, and thus it has been desired that the operation rate of the vacuum pump or the like is further enhanced by reducing the residual amount.

PTL 1: Japanese Patent No. 5562144

An aspect of the present invention have been implemented to solve the problem as described above, and has an object to provide an exhaust system facility that can further enhance the operation rate of the exhaust system facility by reducing the deposition amount of byproducts deposited on the surface of a rotor or casing of a vacuum pump.

In order to solve the foregoing problem, according to a first aspect, there is provided an exhaust-facility system including an exhaust system facility that can be installed downstream of a chamber of a manufacturing apparatus to exhaust the inside of the chamber, and a gas supply device that is connected to the exhaust system facility and can supply the exhaust system facility with a gas containing at least one of hydrogen halide, fluorine, chlorine, chlorine trifluoride, and fluorine radicals.

In this embodiment, out of byproducts remaining in the exhaust system facility, silicon dioxide (SiO₂) occupying most of the byproducts is decomposed by the gas containing at least one of hydrogen halide, fluorine and chlorine trifluoride. For example, hydrogen fluoride (HF) is used to cause the following reaction.

SiO₂ + 4HF → SiF₄ + 2H₂0

The produced silicon fluoride (SiF₄) has a low boiling point and sublimes at -95.5°C, so that it can be easily removed as gas at room temperature. Therefore, it is possible to further reduce the residual amount of byproducts in the exhaust system facility and further enhance the operation rate of the exhaust system facility.

According to experiments, most of silicon dioxide remaining in a vacuum pump, which is one exhaust system facility, became silicon fluoride due to hydrogen fluoride, and could be removed from the vacuum pump. Here, hydrogen halide is a compound of hydrogen and halogen (Group 17 elements of the periodic table, that is, fluorine F, chlorine Cl, bromine Br, iodine I, astatine At). The general formula for hydrogen halide is HX (X is halogen).

The exhaust-facility system includes a vacuum pump, a gas supply device, an abatement apparatus, pipes for connecting these components, pipes for connecting the chamber and the vacuum pump or the abatement apparatus, and the like. (1) The gas supply device + the vacuum pump + the abatement apparatus, (2) the gas supply device + the vacuum pump, (3) the gas supply device + the abatement apparatus, etc. are provided as combinations of the vacuum pump, the gas supply device and the abatement apparatus.

Removal of byproducts by cleaning the vacuum pump using hydrogen halide gas or the like is performed by chemical reaction with cleaning gas, for example, products that inhibit the rotation of the rotor are removed. The removal of the byproducts is neither "reduction of formation of byproducts" nor "suppression of the formation", but "removal of generated byproducts". The removal of byproducts ensures a clearance portion (that is, the gap between a pump body and a rotating body) by removing byproducts. If it is possible to ensure the clearance portion, it is unnecessary to decompose or remove all the byproducts. Maintenance of incidental equipment related to the exhaust system facility and the inside of pipes of the exhaust system is basically unnecessary.

According to a second aspect, the exhaust-facility system according to the first aspect is configured so that the exhaust system facility includes a connection portion with the manufacturing apparatus, and the gas supply device is connected to the exhaust system facility at the connection portion.

According to a third aspect, the exhaust-facility system according to the first or second aspect is configured so that the gas supply device includes a container filled with at least one of hydrogen halide, fluorine, chlorine, and chlorine trifluoride.

According to a fourth aspect, the exhaust-facility system according to any one of the first to third aspects is configured so as to further include a gas temperature control device for controlling the temperature of the gas.

According to a fifth aspect, the exhaust-facility system according to the fourth aspect is configured so that the gas temperature control device controls the temperature of the gas in a range from 50°C to 250°C.

According to a sixth aspect, the exhaust-facility system according to any one of the first to fifth aspects is configured so that a plurality of exhaust system facilities are provided, and the gas is supplied from the gas supply device to the plurality of exhaust system facilities.

According to a seventh aspect, the exhaust-facility system according to any one of the first to sixth aspects is configured so as to further include a water supply apparatus for supplying the gas with water of gas or mist, wherein a mixture of the water and the gas is supplied to the exhaust system facility. Here, the mist means fine particles of liquid dispersed in gas, and also called as fog or droplet.

According to an eighth aspect, the exhaust-facility system according to any one of the first to seventh aspects is configured so as to further include a controller for controlling supply of the gas from the gas supply device to the exhaust system facility, wherein the controller performs the control of the supply of the gas based on a state signal that represents an operation state of the manufacturing apparatus and is output from the manufacturing apparatus.

According to a ninth aspect, the exhaust-facility system according to any one of first to seventh aspects is configured so as to further include a controller for controlling supply of the gas from the gas supply device to the exhaust system facility, wherein the manufacturing apparatus outputs a state signal representing an operation state of the manufacturing apparatus to an abatement apparatus that is installed downstream of the exhaust system facility and processes exhaust gas exhausted from the exhaust system facility to detoxify the exhaust gas, and the controller receives the state signal from the abatement apparatus and performs the control of the supply of the gas based on the received state signal.

According to a tenth aspect, the exhaust-facility system according to any one of the first to seventh aspects is configured so as to further include a controller for controlling supply of the gas from the gas supply device to the exhaust system facility, wherein the controller performs the control of the supply of the gas based on a state signal that is output from the exhaust system facility and represents an operation state of the exhaust system facility.

According to an eleventh aspect, the exhaust-facility system according to any one of the first to eighth aspects and the tenth aspect is configured so that the exhaust system facility includes an abatement apparatus for processing exhaust gas exhausted from the chamber to detoxify the exhaust gas.

According to the twelfth aspect, the exhaust-facility system according to any one of the first to eleventh aspects is configured so that the exhaust system facility includes a vacuum pump.

The removal of byproducts by cleaning using hydrogen halide gas or the like can be applied to removal of byproducts inside an exhaust pipe for connecting the vacuum pump and the abatement apparatus provided downstream of the vacuum pump in addition to the vacuum pump. As a result, it is unnecessary to maintain the pipes for preventing increase of the backpressure of the vacuum pump, or the maintenance frequency is reduced.

The removal of products by cleaning using hydrogen halide gas or the like can also be applied to removal of byproducts inside the abatement apparatus installed on the exhaust side (downstream) of the vacuum pump in addition to the vacuum pump. This eliminates the need for maintenance for removing byproducts adhering to the components of the abatement apparatus, or reduces the maintenance frequency.

According to a thirteenth aspect, the exhaust-facility system according to any one of the first to twelfth aspects is configured so that the manufacturing apparatus is a semiconductor manufacturing apparatus for manufacturing a semiconductor.

According to a fourteenth aspect, the exhaust-facility system according to any one of the first to thirteenth aspects is configured so that the gas supply device has a plasma generator, and the fluorine radicals are generated by the plasma generator.

In an embodiment using fluorine radicals, silicon dioxide (SiO₂) occupying most of byproducts remaining in the exhaust system facility is decomposed by a gas containing fluorine radicals. For example, the following reaction is caused to occur. In the following formula, one molecule of fluorine radicals is represented by FR.

SiO₂ + 4FR → SiF₄ + O₂

There are the following differences between a case where hydrogen fluoride (HF) gas is used and a case where fluorine radicals are generated from nitrogen trifluoride (NF₃) gas. Regarding the use amount of gas, since one molecule of HF contains one atom of F and one molecule of NF₃ contains three atoms of F, the use of nitrogen trifluoride requires a smaller amount of gas to remove an equal amount of byproducts. In other words, in the case of using nitrogen trifluoride, a larger amount of byproducts can be removed with the same amount of gas. Regarding the etching efficiency (that is, the removal efficiency of byproducts with the same volume of gas), in the case of using hydrogen fluoride (HF), gas whose amount was five times as large as a theoretical reaction amount was required, but in the case of using nitrogen trifluoride, a smaller amount of gas was required because radical molecules were used, and thus this case was better.

The following processes are suitable for gas cleaning (removal of byproducts) using hydrogen fluoride (HF). Supply means for hydrogen fluoride is a gas container or the like, and it is simpler than supply means for fluorine radicals, but lower in etching efficiency. Therefore, the gas cleaning using hydrogen fluoride (HF) is suitable for 1) a batch process that has a long time for supplying hydrogen fluoride gas (there is enough time to supply), and 2) a process with a small generation amount of byproducts inside the pump.

On the other hand, the following processes are suitable for gas cleaning using fluorine radicals. Since the gas cleaning using fluorine radicals has a high etching efficiency, but requires a plasma generating apparatus, it is suitable for 1) a single wafer process with a short time for supplying a cleaning gas (there is no extra time to supply), and 2) a process with a large generation amount of byproducts inside the pump.

According to a fifteenth aspect, the exhaust-facility system according to the fourteenth aspect is configured so that the fluorine radicals are generated from nitrogen trifluoride or carbon tetrafluoride in the plasma generator.

According to a sixteenth aspect, the exhaust-facility system according to the fifteenth aspect is configured so that the gas supply device has a container filled with at least one of nitrogen trifluoride and carbon tetrafluoride.

According to a seventeenth aspect, a cleaning method for an exhaust system facility that can be installed downstream of a chamber of a manufacturing apparatus to exhaust the inside of the chamber comprises: providing a gas supply device capable of supplying a gas containing at least one of hydrogen halide, fluorine, chlorine, chlorine trifluoride, and fluorine radicals; connecting the gas supply device to the exhaust system facility; and supplying the gas from the gas supply device to the exhaust system facility.

According to an eighteenth aspect, in the cleaning method according to the seventeenth aspect, the exhaust system facility includes a vacuum pump and/or an abatement apparatus.
Fig. 1 is a block diagram showing an exhaust-facility system according to an embodiment of the present invention;
Fig. 2 is a cross-sectional view showing a vacuum pump shown in Fig. 1;
Figs. 3A and 3B are block diagrams showing configurations of a gas supply device;
Figs. 4A and 4B are block diagrams showing configurations of the gas supply device having a gas temperature control device for controlling the temperature of gas;
Figs. 5A and 5B are block diagrams showing configurations of an exhaust-facility system having a water supply apparatus for supplying gas with water of gas or mist;
Fig. 6 shows components contained in solid byproducts in the vacuum pump, and the weight ratio of each component to the total weight of the solid byproducts in the vacuum pump;
Fig. 7 shows components contained in solid byproducts in the vacuum pump, and the weight ratio of each component to the total weight of the solid byproducts in the vacuum pump;
Fig. 8 is a block diagram showing an embodiment having a plurality of vacuum pumps as a plurality of exhaust system facilities;
Figs. 9A to 9C show state signals when a semiconductor manufacturing apparatus repeats a process step, a cleaning step and an idling step;
Fig. 10 shows a table representing the relationship between each of the process step, the cleaning step and the idling step and opening/closing of a valve;
Fig. 11 shows drive current values of the vacuum pump when the semiconductor manufacturing apparatus is in the process step, the cleaning step and the idling step;
Fig. 12 shows the relationship of the magnitude of the drive current value of the vacuum pump, each step and the presence or absence of supply of HF gas;
Fig. 13 is a block diagram showing an exhaust-facility system according to an embodiment of the present invention;
Fig. 14 is a block diagram showing a configuration of a gas supply device; and
Fig. 15 shows a configuration of a plasma generator.

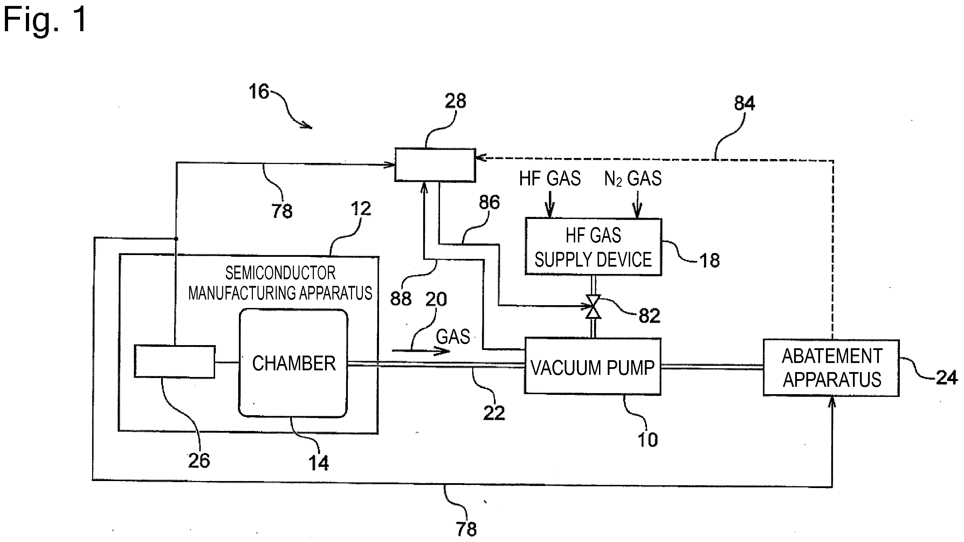

Embodiments according to the present invention will be described hereunder with reference to the accompanying drawings. In the following embodiments, the same or corresponding members are represented by the reference signs, and duplicative descriptions thereof are omitted. Fig. 1 is a block diagram showing an exhaust-facility system according to an embodiment of the present invention. In this embodiment, the exhaust-facility system includes a vacuum pump, a gas supply device, an abatement apparatus, pipes for connecting these devices, a pipe for connecting a chamber and the vacuum pump, etc. An exhaust system facility includes a vacuum pump, an abatement apparatus, a pipe for connecting the vacuum pump and the abatement apparatus, a pipe for connecting a chamber and the vacuum pump, etc. Furthermore, in this embodiment, the manufacturing apparatus is a semiconductor manufacturing apparatus for manufacturing a semiconductor.

Fig. 1 shows an example in which a vacuum pump 10 is connected to a vacuum chamber 14 of a semiconductor manufacturing apparatus 12. An exhaust-facility system 16 includes a vacuum pump 10 which can be installed downstream of the vacuum chamber 14 to exhaust the inside of the vacuum chamber 14 of the semiconductor manufacturing apparatus 12, and a gas supply device 18 capable of supplying a gas containing hydrogen halide to the vacuum pump 10.

In Fig. 1, a process gas supply source (not shown) for supplying process gas to the vacuum chamber 14 is arranged on an upstream side of the vacuum chamber 14. The vacuum chamber 14 is connected to the vacuum pump 10 via a pipe 22.

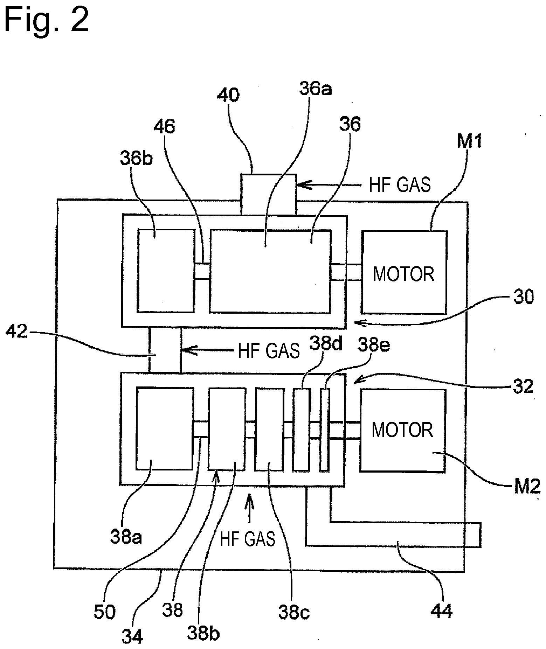

As shown in Fig. 2, for example, the vacuum pump 10 includes a first vacuum pump 30 as a booster pump, a second vacuum pump 32 as a main pump and a housing 34 for housing the first vacuum pump 30 and the second vacuum pump 32. The details of the vacuum pump 10 will be described later.

In Fig. 1, an exhaust gas abatement apparatus 24 (abatement apparatus) for detoxifying exhaust gas 20 (process gas) is arranged on a downstream side of the vacuum pump 10. As types of the exhaust gas abatement apparatus 24 are known a dry adsorption type, a wet absorption (or dissolution) type, a combustion decomposition type, a catalyst type and the like. The catalyst type can be applied to each of the dry adsorption type, the wet absorption (or dissolution) type, and the combustion decomposition type to enhance the abatement efficiency. Heating type (heater type) decomposition and plasma-based decomposition are known as other examples. The exhaust gas abatement apparatus may select any one of these types, or may use a combination of these types. For example, the catalyst type can enhance the abatement efficiency in combination with any type of the dry adsorption type, the wet absorption (or dissolution) type and the combustion decomposition type. Which type should be combined with the abatement apparatus can be appropriately selected in consideration of, for example, the kind and amount of a processing target gas and available utilities. A first controller 26 is connected to the vacuum chamber 14, a process condition for substrate processing (hereinafter referred to as main process) in the vacuum chamber 14 is controlled by the first controller 26. For example, the process condition includes the ventilation time, kind, temperature, etc. of a process gas to be supplied to the vacuum chamber 14. In this embodiment, operation control items of the first controller 26 are a gas flow timing, a gas flow rate, a gas temperature, etc. when the gas type is decided. In this embodiment, particularly, the gas flow rate, the gas temperature, etc. of the gas are fixed, so that information necessary for control is the gas flow timing.

A second controller 28 is connected to the vacuum pump 10 and a valve 82. The operation condition of the vacuum pump 10 and the opening/closing of the valve 82 are controlled by the second controller 28. The operation condition of the vacuum pump 10 includes, for example, the rotation speed of a pump rotor, start timings of the first vacuum pump 30 and the second vacuum pump 32, etc.

The semiconductor manufacturing apparatus, the vacuum pump, and the abatement apparatus can be operated independently of one another. Cooperation among apparatuses is not indispensable. If the pump and the abatement apparatus are started once, the semiconductor manufacturing apparatus can operate independently. However, in standard semiconductor factories, from the viewpoint of energy saving, performance improvement, equipment protection, a cooperative operation based on an operation signal may be performed. In that case, the starting point of signals (control) is the semiconductor manufacturing apparatus. Depending on an instruction of the semiconductor manufacturing apparatus, the vacuum pump and the abatement apparatus change the operation states thereof. Further, the semiconductor manufacturing apparatus changes the operation thereof by signals (abnormality signal, failure signal, etc.) from the vacuum pump and abatement apparatus. In this sense, communication signals are generally bidirectional signals.

In this embodiment, the second controller 28 is independent of and separate from the vacuum pump 10, but the second controller 28 may be provided as a control device equipped in the vacuum pump 10 or a controller appended to the gas supply device 18. The second controller 28 is not required to be a separately installed device.

The second controller 28 is connected to the first controller 26, and a process condition is transmitted as a state signal from the first controller 26 to the second controller 28. The second controller 28 controls the vacuum pump 10 and the valve 82 based on the state signal. In this embodiment, the second controller 28 is not a superordinate control device for the vacuum pump 10, but a subordinate controller for the vacuum pump 10. That is, the gas supply device 18 is an auxiliary device of the vacuum pump 10, and the second controller 28 which is a controller of the gas supply device 18 is a subordinate controller of the vacuum pump 10.

In Fig. 2, the first vacuum pump 30 is an example of a roots type vacuum pump having a pair of roots type pump rotors 36 (only one pump rotor is shown in Fig. 2), and the second vacuum pump 32 is an example of a roots type vacuum pump having a pair of roots type pump rotors 38 (only one pump rotor is shown in Fig. 2). The first vacuum pump 30 and the second vacuum pump 32 have pump rotors having different stages, respectively. The first vacuum pump 30 and the second vacuum pump 32 are installed in parallel to each other in the housing 34, and the first vacuum pump 30 is arranged above the second vacuum pump 32.

An intake pipe 40 is provided at an intake port of the first vacuum pump 30, and the intake pipe 40 is connected to the vacuum chamber 14 via a pipe 22. The semiconductor manufacturing apparatus 12 includes, for example, a film forming apparatus, an etching apparatus or the like that performs film formation processing or etching processing on a substrate such as a semiconductor wafer or a liquid crystal panel. An exhaust port is provided at a lower portion of the first vacuum pump 30, and this exhaust port is connected to the intake port of the second vacuum pump 32 via a connection pipe 42. An exhaust pipe 44 is connected to the exhaust port of the second vacuum pump 32, and gas (process gas, etc.) is exhausted to the outside through the exhaust pipe 44. In addition to the process gas, the gas includes a cleaning gas and an inert gas for dilution. As described above, the first vacuum pump 30 and the second vacuum pump 32 are connected in series to each other, and the second vacuum pump 32 is arranged on the downstream side of the first vacuum pump 30. That is, the first vacuum pump 30 is arranged to be nearer to the vacuum side than the second vacuum pump 32, and the second vacuum pump 32 is arranged on the atmosphere side.

As shown in Fig. 2, the first vacuum pump 30 includes a pair of multistage pump rotors 36 facing each other. Each of the pump rotors 36 includes a first stage roots rotor 36a (intake side rotor) arranged on the intake side, a second stage roots rotor 36b (exhaust side rotor) arranged on the exhaust side, and a rotary shaft 46 to which these roots rotors 36a, 36b are fixed. A motor M1 for driving the first vacuum pump 30 is fixed to an end portion of the rotary shaft 46.

The second vacuum pump 32 differs from the first vacuum pump 30 in that it has a pump rotor of five stages. The other configuration of the second vacuum pump is the same as that of the first vacuum pump, and duplicative description thereof is omitted. As shown in Fig. 2, the second vacuum pump 32 includes a pair of multistage pump rotors 38 facing each other. Each of the pump rotors 38 includes a first stage roots rotor 38a, a second stage roots rotor 38b, a third stage roots rotor 38c, a fourth stage roots rotor 38d, and a fifth stage roots rotor 38e which are arranged in this order from the intake side to the exhaust side, and a rotary shaft 50 to which these roots rotors are fixed. A motor M2 for driving the second vacuum pump 32 is fixed to an end portion of the rotary shaft 50.

Minute gaps are formed between the pump rotors 36 and 38 and between each of the pump rotors 36 and 38 and the inner surface of the rotor casing 34, so that the pump rotors 36 and 38 are rotatable in the rotor casing 34 in a non-contact manner. When byproducts such as SiO₂, etc. are caught in the minute gaps, the rotation of the pump rotors 36, 38 becomes defective or stops. In this embodiment, the roots type is used as the rotor, but the present invention is not limited to the roots type, and a screw type, a claw type or the like may be used. In both the cases, a multistage pump rotor in which rotors of plural stages are arranged in the axial direction is used. Further, the number of stages of the pump rotors 36 and 38 is not limited to two stages and five stages, and may be three or more stages, five or more stages, or five or less stages, respectively.

The exhaust-facility system 16 has an intake pipe 40 which is a connection portion with the semiconductor manufacturing apparatus 12. The gas supply device 18 is connected to the exhaust-facility system 16 at the intake pipe 40. The reason why the gas supply device 18 is connected to the intake pipe 40 resides in that the intake pipe 40 is located upstream of the vacuum pump 10, and thus supply of HF gas from the intake pipe 40 makes it possible to clean the entire vacuum pump 10.

With respect to a place from which HF gas is supplied, HF gas may be supplied from the connection pipe 42 for connecting the first vacuum pump 30 and the second vacuum pump 32. Alternatively, HF gas may be supplied from any place of the second vacuum pump 32 as a main pump. The reason why HF gas is supplied to only the second vacuum pump 32 resides in that the second vacuum pump 32 has higher internal pressure and higher internal temperature than the first vacuum pump 30, and thus it is a place where products are more likely to be generated. A place where byproducts are likely to be caught or a place where byproducts are likely to be generated changes depending on the manufacturing process or the like of the semiconductor manufacturing apparatus 12.

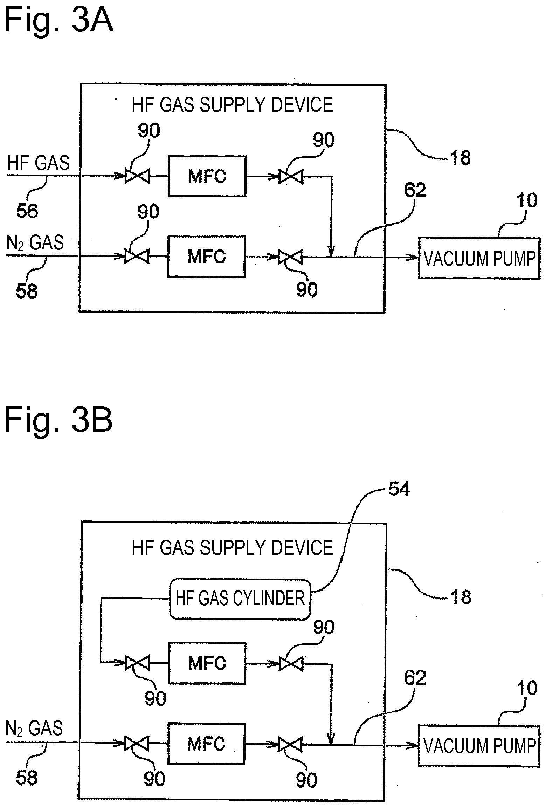

Next, the gas supply device 18 will be described with reference to Figs. 3A and 3B. Figs. 3A and 3B are block diagrams showing configurations of the gas supply device 18. Fig. 3A shows a case where HF gas and N₂ gas are supplied from the outside of the exhaust-facility system 16 to the gas supply device 18. The HF gas is supplied via a pipe 56, and the N₂ gas is supplied via a pipe 58. Fig. 3B shows a case where the gas supply device 18 has a container 54 filled with hydrogen halide, and N₂ gas is supplied from the outside of the exhaust-facility system 16.

N₂ gas is used to adjust the concentration of HF gas. The HF gas supply device 18 supplies the vacuum pump 10 with HF gas and N₂ gas supplied to the gas supply device 18 at an optimal HF concentration, an optimal flow rate and an optimal supply timing. The HF gas and the N₂ gas are mixed with each other, and then sent to the vacuum pump 10. MFC in Figs. 3A and 3B represents a mass flow controller. Valves 90 for opening/closing the pipes are provided before and after MFC. In place of MFC, the same function may be realized by using a mass flow meter and an ON/OFF valve such as a solenoid valve and a flow rate control valve which are remotely operated. When using the container 54, it is unnecessary to supply HF gas from the outside of the exhaust-facility system 16, and a long pipe for supplying HF gas from the outside is unnecessary. Therefore, the installation work is facilitated, and the cost is reduced.

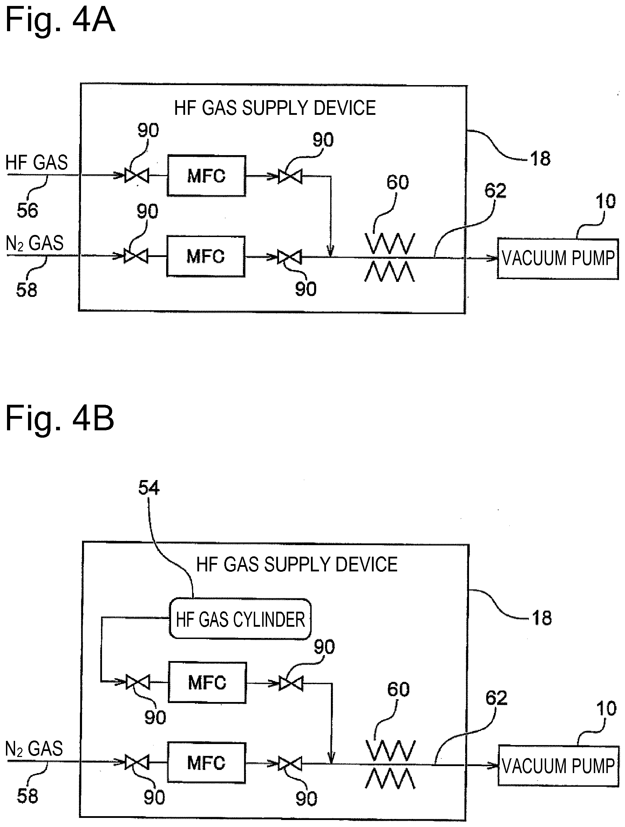

Next, another embodiment of the gas supply device 18 will be described with reference Figs. 4A and 4B. Figs. 4A and 4B are block diagrams showing configurations of the gas supply device 18 having a heater 60 for heating (gas temperature control device) for controlling the temperature of gas. Fig. 4A shows a case where HF gas and N₂ gas are supplied from the outside of the exhaust-facility system 16 to the gas supply device 18. Fig. 4B shows a case where the gas supply device 18 has a container 54 filled with hydrogen halide, and N₂ gas is supplied from the outside of the exhaust-facility system 16.

The heater 60 for heating automatically controls the heating of HF gas to a temperature optimal for cleaning. The optimal temperature for cleaning ranges from 50°C to 250°C in the case of the reaction for producing silicon fluoride from silicon dioxide as described above. Below this temperature range, the reaction is weak, and above this temperature range, it will influence the operation of the device. If the reaction is weak, silicon dioxide cannot be removed sufficiently. The influence on the apparatus means that each part of the apparatus may be damaged due to deformation or corrosion caused by local heating.

The heater 60 for heating is wound around the outer periphery of the pipe 62. The temperature of HF gas is measured by a temperature sensor, and the second controller 28 controls the output of the heater 60 for heating based on the measured temperature. In place of the arrangement of the gas temperature control device in the gas supply device 18, the gas temperature control device may be arranged in the vacuum pump 10.

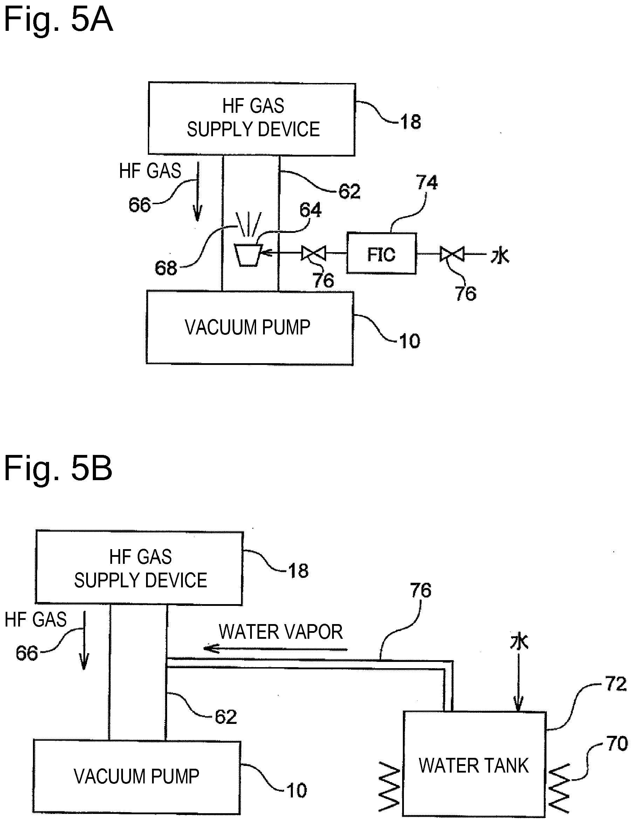

Next, another embodiment of the exhaust-facility system 16 will be described with reference to Figs. 5A and 5B. Figs. 5A and 5B are block diagrams showing configurations of the exhaust-facility system 16 having a water supply apparatus for supplying gas with water of gas or mist. In this exhaust-facility system 16, a mixture of water and gas is supplied to the vacuum pump 10. HF gas to be supplied to the vacuum pump 10 is accompanied by water, and byproducts in the vacuum pump 10 are reacted with the HF gas by using the water. A moderate amount of moisture improves the efficiency of the reaction to produce silicon fluoride from silicon dioxide as described above.

In Fig. 5A, a spray nozzle 64 for discharging water in the form of mist is arranged in a pipe 62 for connecting the gas supply device 18 and the vacuum pump 10. The water supply apparatus has the spray nozzle 64, and a flow rate controller 74 (FIC) and valves 76 which adjust the amount of water to be discharged from the spray nozzle 64. Water is supplied from the outside of the exhaust-facility system 16 to the flow rate controller 74. The spray nozzle 64 discharges water in a direction 68 opposite to a flow direction 66 of HF gas. The reason why water is discharged in the opposite direction 68 resides in that HF gas and water are well mixed with each other.

In Fig. 5B, the water supply apparatus includes a water tank 72 having a heating device 70. The water is supplied from the outside of the exhaust-facility system 16 to the water tank 72. A pipe 88 protruding from the upper portion of the water tank 72 equipped with the heating device 70 is connected to a pipe 62 for connecting the gas supply device 18 and the vacuum pump 10. Since the inside of the pipe 62 is evacuated by the vacuum pump 10, the interior of the water tank 72 is kept in a vacuum state. Therefore, water vapor is generated in the water tank 72, and the inside of the water tank 72 is set at low temperature due to heat of evaporation. In order to prevent the temperature of the water from decreasing until the water changes to ice, a heating device 70 is provided. Water vapor is supplied to byproducts inside the vacuum pump 10 together with HF gas.

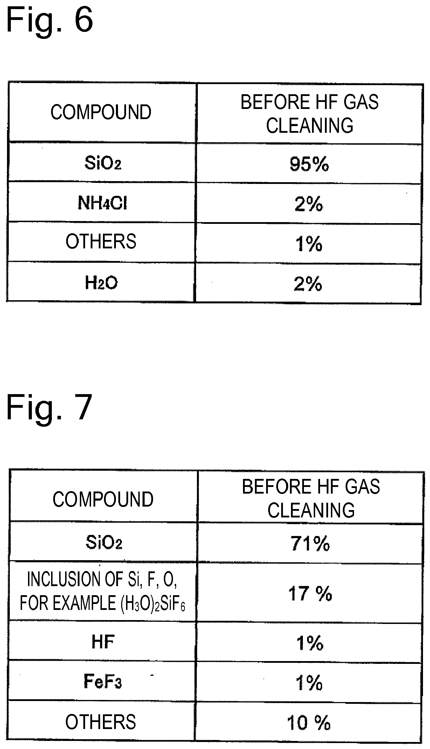

Next, Fig. 6 shows a test result confirming how much byproducts remaining in the vacuum pump 10 have been removed by hydrogen halide when a gas containing hydrogen halide is supplied to the vacuum pump 10. In this test, residual solid byproducts were collected from the inside of the actually used vacuum pump 10 into a container. A gas containing hydrogen halide was supplied to the byproducts in the container. The weight of the solid byproducts in the container was measured before the gas was supplied and after the test was finished. In the test, the gas containing hydrogen halide was supplied over a set period of time.

Fig. 6 shows components contained in the solid byproducts in the container and the weight ratio of each component to the total weight of the solid byproducts in the container before supply of the gas. Before supply of the gas, silicon dioxide accounted for 95%. After the reaction with the gas was finished, the weight of silicon dioxide was measured. The result indicated that the weight of silicon dioxide greatly decreased to a detectable weight or less. The solid byproducts in the container almost disappeared visually. It is considered that most of solid silicon dioxide has changed to gaseous silicon fluoride (SiF₄) and ammonium fluorosilicate ((NH₄)₂SiF₆).

Fig. 7 shows a test result regarding a different process from that of Fig. 6. This test was a test using solid byproducts which remained inside the vacuum pump 10 used in a semiconductor manufacturing process different from that of Fig. 6. The solid byproducts remaining in the vacuum pump 10 used in the semiconductor manufacturing process different from that of Fig. 6 were collected in a container. A gas containing hydrogen halide was supplied into the container, and the weight of the solid byproducts in the container was measured before the gas was supplied and after the reaction with the gas was finished.

Fig. 7 shows components contained in solid byproducts in a glass container, and the weight ratio of each component to the total weight of the solid byproducts in the container before gas was filled. Before the gas was supplied, silicon dioxide accounted for 71%. After the reaction with the gas was finished, the weight of silicon dioxide was measured. The result indicated that the weight of silicon dioxide greatly decreased to a detectable weight or less. The inclusion of Si, F, O accounted for 17%. After the reaction with the gas was finished, the weight of the inclusion of Si, F, O was measured. The result indicated the weight of the inclusion of Si, F, O greatly decreased to a detectable weight or less. The solid byproducts in the container almost disappeared visually. It is considered that most of the inclusion of Si, F, O changed to gaseous silicon fluoride (SiF₄) and so on.

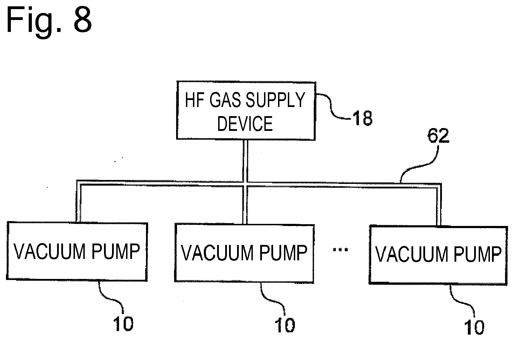

Next, an embodiment of an exhaust-facility system in which gas is supplied from gas supply device to a plurality of exhaust system facilities will be described with reference to Fig. 8. Fig. 8 is a block diagram of an embodiment having a plurality of vacuum pumps 10 as a plurality of exhaust system facilities. HF gas is supplied from one HF gas supply device 18 to a plurality of vacuum pumps 10. In order to receive the HF gas, the vacuum pump 10 has a connection portion with the pipe 62. The connection portion is a screw type connector or the like.

Next, a control method when gas is supplied from the gas supply device to the exhaust system facility will be described with reference to Fig. 1. The exhaust-facility system 16 has a second controller 28 for controlling supply of gas from the gas supply device 18 to the vacuum pump 10. The second controller 28 performs control based on a state signal 78 which is output from the semiconductor manufacturing apparatus 12 and represents the operation state of the semiconductor manufacturing apparatus 12.

The state signal 78 representing the operation state of the semiconductor manufacturing apparatus 12 will be described hereunder. For example, the process performed by the semiconductor manufacturing apparatus 12 for forming film on a wafer includes a "process step" for performing film formation, a "cleaning step" executed to recover the internal environment of the semiconductor manufacturing apparatus 12 contaminated by the "process step" to a clean state, and an "idling step" which is a standby state other than the foregoing steps. The removal of byproducts inside the vacuum pump 10 by HF gas is not influenced by the operation state of the semiconductor manufacturing apparatus 12. The removal of byproducts inside the vacuum pump 10 is possible in any step of the foregoing steps. However, during the process step, it is necessary to eliminate the possibility that the removal of byproducts inside the vacuum pump 10 may influence the operation state (film formation quality) of the semiconductor manufacturing apparatus 12. Therefore, it is necessary to prevent HF gas from being mixed into the semiconductor manufacturing apparatus 12 from the vacuum pump 10. During the process step, it is undesirable to execute cleaning of the vacuum pump 10 with HF gas. Therefore, in order to avoid supply of HF gas to the vacuum pump 10 when the semiconductor manufacturing apparatus 12 is under the process step, it is desirable to perform cleaning with HF gas of the vacuum pump 10 in a step other than the process step. In order to determine whether the step is the process step or not, the state signal 78 representing the operation state of the semiconductor manufacturing apparatus 12 is used.

Here, with respect to the state signal 78, the following use method is also possible. The gas type and the gas flow rate used in the semiconductor manufacturing apparatus 12 differ among the "process step", the "cleaning step", and the "idling step". In the case of the exhaust gas abatement apparatus 24, particularly a combustion type abatement apparatus, it is necessary to perform combustion under an optimal combustion condition according to the gas type and the gas flow rate. That is, it is necessary to optimize the removal efficiency of a processing target gas in the exhaust gas abatement apparatus 24. Accordingly, the exhaust gas abatement apparatus 24 receives, from the first controller 26 of the semiconductor manufacturing apparatus 12, the state signal 78 indicating which step the semiconductor manufacturing apparatus 12 is performing, grasps the operation state of the semiconductor manufacturing apparatus 12, and realizes a combustion condition suitable for the grasped operation state.

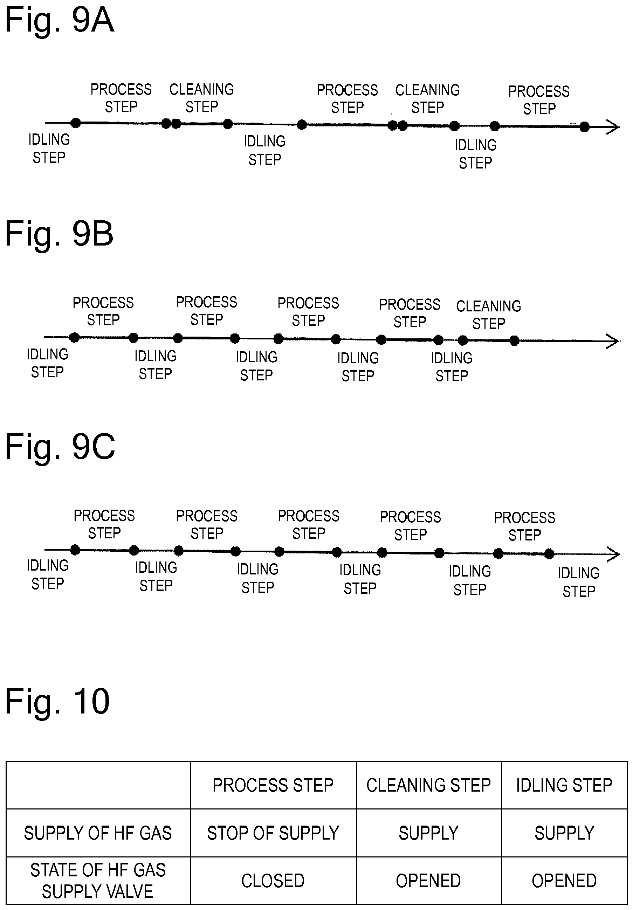

Examples of the state signal 78 are shown in Figs. 9A to 9C. Fig. 9A shows a state signal 78 when the semiconductor manufacturing apparatus 12 repeats the process step, the cleaning step, and the idling step in this order. The state signal 78 may be set to, for example, "0", "1" or "2" of a digital signal to identify the process step, the cleaning step and the idling step. Further, the state signal 78 may be set as an analog signal having a signal level of three stages. In Fig. 9B, the semiconductor manufacturing apparatus 12 performs the cleaning step after repeating the process step and the idling step at plural times (Fig. 9B shows a case of four times). Fig. 9B shows a state signal 78 when the semiconductor manufacturing apparatus 12 repeats this order. Fig. 9C shows a state signal 78 when the semiconductor manufacturing apparatus 12 repeats only the process step and the idling step in this order.

It will be described with reference to a table shown in Fig. 10 whether HF gas is supplied to the vacuum pump 10 when the semiconductor manufacturing apparatus 12 performs each of the process step, the cleaning step and the idling step. The table of Fig. 10 shows the relationship of each step, the presence or absence of supply of HF gas and the opening/closing of the valve 82. As shown in the table of Fig. 10, no HF gas is supplied in the process step. HF gas is supplied in both of the cleaning step and the idling step. In each step, the second controller 28 outputs, to the valve 82, a signal 86 for controlling the opening/closing of the valve 82 which is a valve for supplying HF gas. Based on the signal 86, the second controller 28 closes the valve 82 in the process step and opens the valve in both the cleaning step and the idling step.

The second controller 28 receives the state signal 78 from the first controller 26, but the second controller 28 may receive the state signal 78 via another route. That is, since the exhaust gas abatement apparatus 24 receives the state signal 78 from the first controller 26, the second controller 28 can receive a state signal 84 identical to the state signal 78 from the exhaust gas abatement apparatus 24. The second controller 28 controls the valve 82 as shown in Fig. 10 based on the state signal 84 output from the exhaust gas abatement apparatus 24.

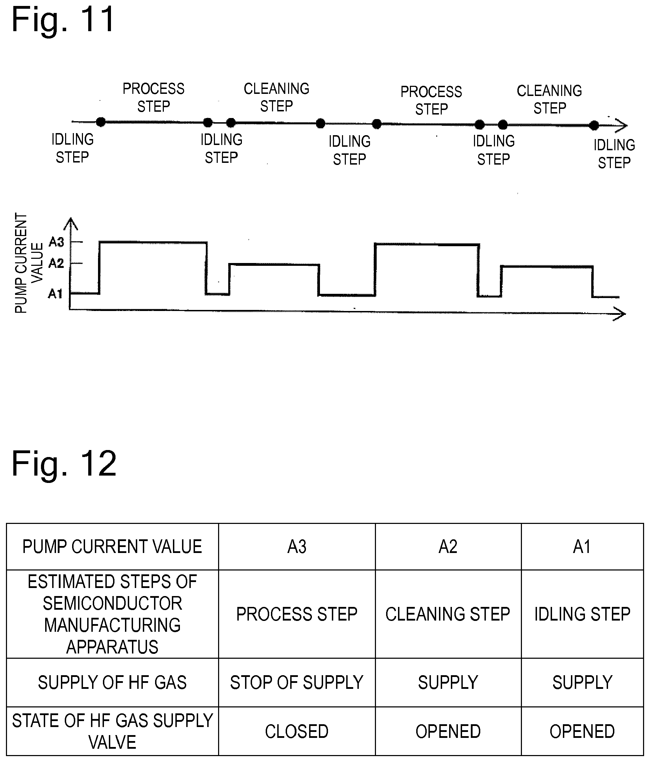

Next, another embodiment of the control method by the second controller 28 will be described with reference to Fig. 11. In this embodiment, the control of supply or stop of supply of HF gas from the gas supply device 18 to the vacuum pump 10 is performed by determining the operation state of the semiconductor manufacturing apparatus 12 from the state signal of the vacuum pump 10. The second controller 28 controls supply of HF gas based on a state signal 88 which is output from the exhaust system facility, for example, the vacuum pump 10 and represents the operation state of the vacuum pump 10. Fig. 11 shows a drive current value of the vacuum pump 10 when the semiconductor manufacturing apparatus 12 is in the process step, the cleaning step, and the idling step. The abscissa axis of Fig. 11 represents the time, and the ordinate axis represents the drive current value (A: ampere). In this embodiment, the drive current value is the state signal 88 of the vacuum pump 10.

The magnitude of the drive current value of the vacuum pump 10 is equal to A3 in the process step, A2 in the cleaning step and A1 in the idling step, and in this embodiment, the magnitude of the drive current value decreases in the order of the process step, the cleaning step, and the idling step. The relationship between the semiconductor manufacturing process and the pump current is conceptually shown in Fig.11. Actually, the relationship is not necessarily represented by a simple pulse waveform as shown in Fig. 11. However, the process step, the cleaning step, and the idling step can be distinguished from one another by the magnitude of the drive current value of the vacuum pump 10.

It will be described with reference to a table shown in Fig. 12 whether HF gas is supplied to the vacuum pump 10 when the semiconductor manufacturing apparatus 12 performs the process step, the cleaning step, and the idling step. The table in Fig. 12 shows the relationship of the magnitude of the drive current value of the vacuum pump 10, each step, the presence or absence of supply of HF gas, and the opening/closing of the valve 82. As shown in the table of Fig. 12, no HF gas is supplied in the process step, and HF gas is supplied in both the cleaning step and the idling step. In each step, the second controller 28 outputs a signal 86 for controlling the opening/closing of the valve 82 to the valve 82. Based on the signal 86, the second controller 28 closes the valve 82 in the process step, and opens the valve 82 in the cleaning step and the idling step.

In the exhaust-facility system 16 shown in Fig. 1, a method of cleaning the vacuum pump 10 that can be installed downstream of the chamber 14 in order to exhaust the inside of the chamber 14 of the semiconductor manufacturing apparatus 12 is as follows. The gas supply device 18 capable of supplying a gas containing hydrogen halide is provided in the exhaust-facility system 16. The gas supply device 18 is connected to the vacuum pump 10. The gas is supplied from the gas supply device 18 to the vacuum pump 10.

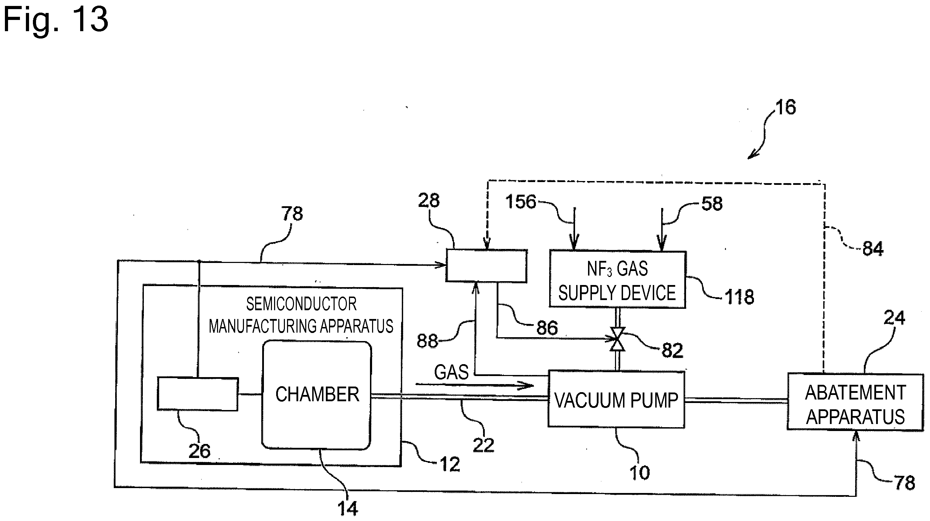

An embodiment in which the gas supply device has a plasma generator, and fluorine radicals are generated by the plasma generator will be described with reference to Figs. 13 to 15. Fluorine radicals are generated, for example from nitrogen trifluoride or carbon tetrafluoride in the plasma generator. In Fig. 13, the exhaust-facility system 16 has a gas supply device 118 capable of supplying a gas containing fluorine radicals to the vacuum pump 10.

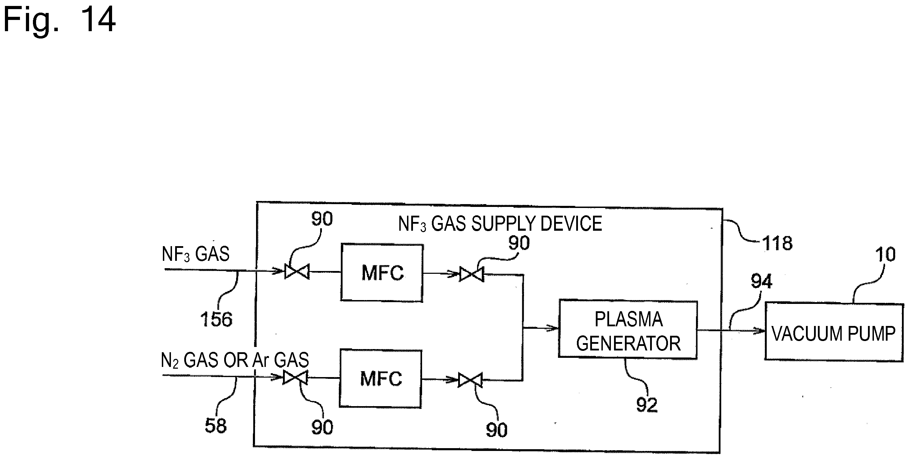

Next, the gas supply device 118 will be described with reference to Fig. 14. Fig. 14 is a block diagram showing a configuration of the gas supply device 118, and shows a case where NF₃ gas and N₂ gas (and/or Ar gas) are supplied to the gas supply device 118 from the outside of the exhaust-facility system 16. NF₃ gas is supplied via a pipe 156, and the N₂ gas is supplied via a pipe 58. N₂ gas is used to adjust the concentration of NF₃ gas.

The NF₃ gas and the N₂ gas supplied to the gas supply device 118 are supplied to the plasma generator 92 at an optimal NF₃ concentration, an optimal flow rate and an optimal supply timing. The NF₃ gas and the N₂ gas are mixed with each other, and then sent to the plasma generator 92. The plasma generator 92 generates a fluorine radical gas 94 and supplies the fluorine radical gas 94 to the vacuum pump 10.

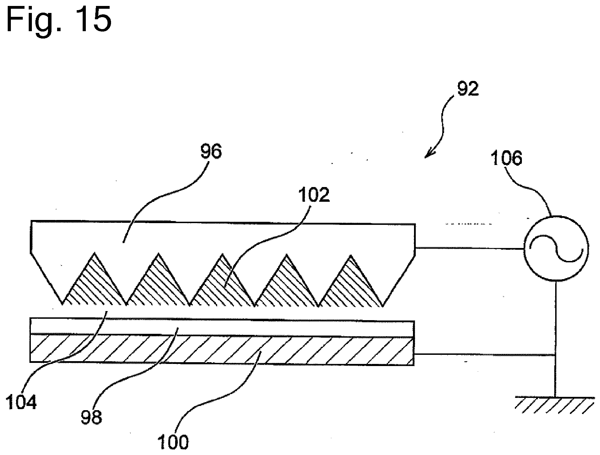

Next, the plasma generator 92 will be described with reference to Fig. 15. There are various methods for generating plasma. Any method of generating plasma can be applied to this embodiment. For example, a barrier discharge method, a creeping discharge method, a high frequency discharge method, and the like are be used as the method of generating plasma. Fig. 15 shows one type of barrier discharge method. The plasma generator 92 includes a high-voltage electrode 96 provided with V-shaped trench grooves 102, a dielectric plate 98, and a ground electrode 100. A minute clearance (gap) is provided between the trench grooves 102 of the high voltage electrode 96 and the dielectric plate 98 to form a discharge space 104. The trench grooves 102 are filled with dielectric substance. NF3 gas and N₂ gas are supplied to the discharge space 104.

A high voltage having a high frequency is applied between the high voltage electrode 96 and the ground electrode 100 by a high voltage AC power supply 106. When the high voltage having a high frequency is applied, corona discharge (silent discharge) occurs in the discharge space 104. Fluorine in the NF₃ gas led to the discharge space 104 is converted into fluorine radicals by discharge energy. The barrier discharge method has an advantage that a discharge starting voltage is low, the generation amount of fluorine radicals is large, and the concentration of fluorine radicals is high.

Although the embodiments of the present invention have been described above, the embodiments of the invention described above are presented to facilitate understanding of the present invention, and do not limit the present invention. The present invention can be changed and improved without departing from the subject matter of the present invention, and it is needless to say that the present invention includes equivalents thereof. In addition, it is possible to arbitrarily combine or omit the respective constituent elements described in the claims and the specification in a range in which at least a part of the above-mentioned problem can be solved or a range in which at least a part of the effect is exhibited.
- 10: vacuum pump
- 12: semiconductor manufacturing apparatus
- 14: vacuum chamber
- 16: exhaust-facility system
- 18: gas supply device
- 20: exhaust gas
- 22: pipe
- 24: exhaust gas abatement apparatus
- 26: first controller
- 28: second controller

## Claims

1. An exhaust-facility system comprising:
an exhaust system facility that can be installed downstream of a chamber of a manufacturing apparatus to exhaust the inside of the chamber; and
a gas supply device that is connected to the exhaust system facility and can supply the exhaust system facility with a gas containing at least one of hydrogen halide, fluorine, chlorine, chlorine trifluoride, and fluorine radicals.

2. The exhaust-facility system according to claim 1, wherein the exhaust system facility has a connection portion with the manufacturing apparatus, and the gas supply device is connected to the exhaust system facility at the connection portion.

3. The exhaust-facility system according to Claim 1 or 2, wherein the gas supply device includes a container filled with at least one of hydrogen halide, fluorine, chlorine, and chlorine trifluoride.

4. The exhaust-facility system according to any one of claims 1 to 3, further comprising a gas temperature control device for controlling the temperature of the gas.

5. The exhaust-facility system according to claim 4, wherein the gas temperature control device controls the temperature of the gas in a range from 50°C to 250°C.

6. The exhaust-facility system according to any one of claims 1 to 5, wherein a plurality of exhaust system facilities are provided, and the gas is supplied from the gas supply device to the plurality of exhaust system facilities.

7. The exhaust-facility system according to any one of claims 1 to 6, further comprising a water supply apparatus for supplying the gas with water of gas or mist, wherein a mixture of the water and the gas is supplied to the exhaust system facility.

8. The exhaust-facility system according to any one of claims 1 to 7, further comprising a controller for controlling supply of the gas from the gas supply device to the exhaust system facility, wherein the controller performs the control of the supply of the gas based on a state signal that represents an operation state of the manufacturing apparatus and is output from the manufacturing apparatus.

9. The exhaust-facility system according to any one of claims 1 to 7, further comprising a controller for controlling supply of the gas from the gas supply device to the exhaust system facility,
wherein the manufacturing apparatus outputs a state signal representing an operation state of the manufacturing apparatus to an abatement apparatus that is installed downstream of the exhaust system facility and processes exhaust gas exhausted from the exhaust system facility to detoxify the exhaust gas, and
the controller receives the state signal from the abatement apparatus and performs the control of the supply of the gas based on the received state signal.

10. The exhaust-facility system according to any one of claims 1 to 7, further comprising a controller for controlling supply of the gas from the gas supply device to the exhaust system facility, wherein the controller performs the control of the supply of the gas based on a state signal that is output from the exhaust system facility and represents an operation state of the exhaust system facility.

11. The exhaust-facility system according to any one of claims 1 to 8 and claim 10, wherein the exhaust system facility includes an abatement apparatus for processing exhaust gas exhausted from the chamber to detoxify the exhaust gas.

12. The exhaust-facility system according to any one of claims 1 to 11, wherein the exhaust system facility includes a vacuum pump.

13. The exhaust-facility system according to any one of claims 1 to 12, wherein the manufacturing apparatus is a semiconductor manufacturing apparatus for manufacturing a semiconductor device.

14. The exhaust-facility system according to any one of claims 1 to 13, wherein the gas supply device has a plasma generator, and the fluorine radicals are generated by the plasma generator.

15. The exhaust-facility system according to claim 14, wherein the fluorine radicals are generated from nitrogen trifluoride or carbon tetrafluoride in the plasma generator.

16. The exhaust-facility system according to claim 15, wherein the gas supply device has a container filled with at least one of nitrogen trifluoride and carbon tetrafluoride.

17. A cleaning method for an exhaust system facility that can be installed downstream of a chamber of a manufacturing apparatus to exhaust the inside of the chamber comprising:
providing a gas supply device capable of supplying a gas containing at least one of hydrogen halide, fluorine, chlorine, chlorine trifluoride, and fluorine radicals;
connecting the gas supply device to the exhaust system facility; and
supplying the gas from the gas supply device to the exhaust system facility.

18. The cleaning method according to claim 17, wherein the exhaust system facility includes a vacuum pump and/or an abatement apparatus for processing exhaust gas exhausted from the chamber to detoxify the exhaust gas.
